# EUROPEAN PATENT SPECIFICATION

(11) **EP 1 916 708 B1**
(45) Date of publication and mention of the grant of the patent: **22.05.2013**
(21) Application number: 07119098.7
(22) Date of filing: 23.10.2007
(51) Int. Cl.: H01L 21/3213

(54) **Patterning of doped poly-silicon gates**
Strukturierung dotierter Polysilizium-Gates
Formation de motif de grille en silicium polycristallin dopé

(30) Priority: 22.06.2007 US 945864 P; 23.10.2006 US 853895 P
(43) Date of publication of application: 30.04.2008
(73) Proprietor: IMEC, 3001 Leuven (BE)
(72) Inventor: Demand, Marc, B-1370 Saint-Jean-Geest (BE); Shamiryan, Denis, B-3001 Leuven (BE); Paraschiv, Vasile, B-3010 Kessel-Lo (BE)
(74) Representative: Pronovem

(56) References cited:
- US-A1- 2006 286 802
- DEMAND M, PARASCHIV V, SHAMIRYAN D, VRANCKEN C, BRUS S, VELOSO A, BOULLART W: "Dry etch of Yb-doped polys-Si gates for low Vt FUSI devices" 1ST INTERNATIONAL WORKSHOP ON PLASMA ETCH AND STRIP IN MICROELECTRONICS, 10-11 SEPTMEBER 2007, LEUVEN, BELGIUM, PRESENTATION AND ABSTRACT, 11 September 2007 (2007-09-11), XP002530204 retrieved from http://www.pesm2007.be/03.pdf and from http://www.pesm2007.be/05_02_demand.pdf
- CHIEN-TING LIN ET AL: "CMOS Dual-Work-Function Engineering by Using Implanted Ni-FUSI" IEEE ELECTRON DEVICE LETTERS, IEEE SERVICE CENTER, NEW YORK, NY, US, vol. 28, no. 9, 1 September 2007 (2007-09-01), pages 831-833, XP011190980 ISSN: 0741-3106
- YU H Y ET AL: "Advanced Ni-based FUlly SIlicidation (FUSI) technology for sub-45nm CMOS devices" SOLID-STATE AND INTEGRATED CIRCUIT TECHNOLOGY, 2006. ICSICT '06. 8TH INTERNATIONAL CONFERENCE ON, IEEE, PI, 1 October 2006 (2006-10-01), pages 404-407, XP031045601 ISBN: 978-1-4244-0160-4
- CHEN J D ET AL: "YB-DOPED NI FUSI FOR THE N-MOSFETS GATE ELECTRODE APPLICATION" IEEE ELECTRON DEVICE LETTERS, IEEE SERVICE CENTER, NEW YORK, NY, US, vol. 27, no. 3, 1 March 2006 (2006-03-01), pages 160-162, XP001240564 ISSN: 0741-3106

## Description

### FIELD OF THE INVENTION

The present invention is related to the field of semiconductor processing. More specifically it is related to the patterning of poly-Silicon (Poly-Si) doped with an element that does not form volatile compounds during conventional reactive ion etching.

The invention is further related to a method to pattern Ytterbium (Yb) doped poly-Si (gates) or in other words makes it possible to etch Yb doped poly-Si gates using a combination of dry and wet etching.

### BACKGROUND OF THE INVENTION

The transistor's work function can be modulated using dopants in combination with fully silicided gates. The use of an activation anneal of these dopants has been shown to have a strong effect on the work function modulation achieved. Aluminium (Al) can be used as dopant to fabricate poly-Si gate for p-MOS transistors whereas Ytterbium (Yb) doped poly-Si gate will be used for n-MOS transistors. In the complementary MOS (CMOS) transistor flow, the gates might receive the implants (Yb and Al) before the gate patterning or just before the silicidation. In the former case they can receive the anneal from the junction anneal, whereas in the latter case they will not get an activation anneal because the integrity of the NiSi source drain regions could not be preserved.

Since Yb is not likely to form volatile compounds during dry etching the problem is the selective etching of Yb doped gates without leaving residues leading to unwanted micro-masking.

### SUMMARY

The present invention provides a method for etching poly-Si gates doped with an element, in particular a lanthanide , that does not form volatile compounds during conventional reactive ion etching, such as Ytterbium (Yb).

The invention further provides a method for patterning a gate structure comprising Lanthanide elements, preferably Ytterbium, using a combination of a dry etch plasma and a wet removal step, thereby avoiding micromasking and unwanted residues.

More generally, the present invention provides a method for the manufacture of a semiconductor device comprising selectively removing, at least partly, a lanthanide doped layer over a layer underneath, said selective removal comprising the steps of:
- subjecting the exposed part of the lanthanide doped layer, to a Cl-comprising plasma and/or a Br-comprising plasma for chlorinating and/or for brominating said lanthanide(s),
- contacting or rinsing the resulting chlorinated and/or brominated doped layer with an aqueous solution, preferably with water.

By said contacting (e.g. dipping) or rinsing step, the resulting chlorinated and/or brominated layer, in particular the resulting chlorinated and/or brominated rare earth(s), dissolve(s) in the aqueous solution (preferably in water). In other words, the resulting chlorinated and/or brominated rare earth(s), being water soluble, are removed with an aqueous solution, preferably with water.

In a method of the invention, said subjecting step and said contacting step can be repeated (at least once). More particularly, said subjecting step and said contacting step can be repeated for the complete removal of said lanthanide doped layer, said removal being possibly limited to a delimited (or restricted) area.

In particular, said plasma is preferably anisotropically applied, whereby a delimited area is chlorinated and/or brominated.

Preferably, in a method of the invention, said lanthanide(s) is/are selected from the group consisting of La, Dy, Pr, Nd, Gd, Tb, Ho, Er, Tm, Yb and Lu.

According to a preferred embodiment, said lanthanide is ytterbium, Yb.

Preferably, in a method of the invention, said lanthanide(s) in said doped layer is/are in a concentration of less than 10%, more preferably of less than 5%, more preferably of less than 2%, and even more preferably of less than 1%, but not null (i.e. higher than 0).

In a method of the invention, said Cl-comprising plasma is preferably a Cl₂ and/or BCl₃ comprising plasma.

In a method of the invention, said Br-comprising plasma is preferably a HBr and/or Br₂ comprising plasma.

In a method of the invention, said chlorination and said bromination can be performed sequentially, both orders being envisaged, or can be performed simultaneously.

In particular, the term "Cl-comprising plasma and/or Br-comprising plasma" also encompasses a Cl- and/or Br-comprising plasma.

In a method of the invention, said Cl- and/or Br-comprising plasma does not contain fluorine or fluorine containing compounds.

In a method of the invention, inert compounds, such as argon, helium, and/or nitrogen can be added to said plasma.

Preferably, in a method of the invention, said lanthanide doped layer consists of a layer suitable for dry-etching, wherein said rare earth(s) has/have been introduced.

In other words, the matrix or main composition of said layer is suitable for dry-etching, while said introduced rare earth(s) need to be chlorinated and/or brominated for further removal with an aqueous solution, preferably with water (by contacting or rinsing).

Said doped layer can consist of a metal layer suitable for dry-etching, wherein said rare earth(s) has/have been introduced.

Said doped layer can consist of a silicon, silicon-oxide, silicon-germanide, silicon-nitride, silicon-carbide, silicon-oxy-carbide, or germanium layer, wherein said rare earth(s) has/have been introduced.

More preferably, in a method of the invention, said layer underneath is polycrystalline silicon.

Said substrate can comprise (or consist of) silicon (preferably polycrystalline silicon), silicon-oxide, silicon-germanide, silicon-nitride, silicon-carbide, silicon-oxy-carbide, or germanium.

More preferably, in a method of the invention, said substrate is polycrystalline silicon.

A method for the manufacture of a semiconductor device comprising selectively removing, at least partly, a lanthanide doped layer over a layer underneath according to the present invention is used for patterning a structure, such as a gate structure in a semiconductor device.

In particular, a method is provided for patterning a stack of layers comprising at least one lanthanide doped layer, said method comprising the steps of:
- developing a mask structure for defining a structure on a lanthanide doped layer,
- exposing part of said lanthanide doped layer,
- selectively removing said exposed part of said lanthanide doped layer according to a method of any of claims 1 to 11,
- annealing the final structure such that said lanthanide(s) is/are equally distributed into the doped layer.

A method for patterning can further comprise, before the step of developing a mask structure, the steps of:
- depositing photosensitive imaging layers, and
- transferring a photolithographic pattern in said imaging layers to define the gate structure.

Preferably, in a method for patterning according to the invention, the step of annealing is performed at a temperature comprised between about 700°C and about 1100°C.

More preferably, in a method for patterning according to the invention, the step of annealing is performed using a thermal anneal at 950°C (e.g. in a furnace or in a Rapid Thermal Annealing Tool).

In a method for patterning according to the invention, the step of annealing can also be performed using a laser anneal.

Preferably, in a method for patterning according to the invention, said structure is a gate structure in a semiconductor device, said lanthanide doped layer is a gate electrode layer. In particular, before the step of depositing the gate electrode layer, a gate dielectric layer is deposited.

Preferably, in a method for patterning according to the invention, said doped layer, used as a gate electrode layer, is a poly-crystalline silicon layer and said underneath layer, used as a gate dielectric, is a high-k layer (i.e. a layer of a material having a dielectric constant, k, higher than that of SiO₂), a SiO₂ layer, or a SiON layer. Said gate dielectric layer can be further etched to complete the gate structure.

### SHORT DESCRIPTION OF THE DRAWINGS

All drawings are intended to illustrate some aspects of the present invention. Not all alternatives and options are shown and therefore the invention is not limited to the content of the given drawings.

Figure 1A illustrates a tilted SEM picture of an Yb-doped poly-Si gate after etch using conventional poly-Si gate etch recipe. Figure 1B illustrates a tilted SEM picture of an Yb-doped poly-Si gate after etch using a conventional poly-Si gate etch recipe and an anneal in N₂ at 900°C to distribute the Yb in the poly-Si layer.

Figure 2 illustrates a flowchart according to a preferred embodiment of the invention to perform the dry/wet/dry etch approach for patterning of poly-Si doped with almost non-volatile elements (e.g. Yb).

Figure 3A up to Figure 31 illustrate the different processing steps according to a preferred embodiment of the invention to perform the dry/wet/dry etch approach for patterning of poly-Si doped with almost non-volatile elements (e.g. Yb).

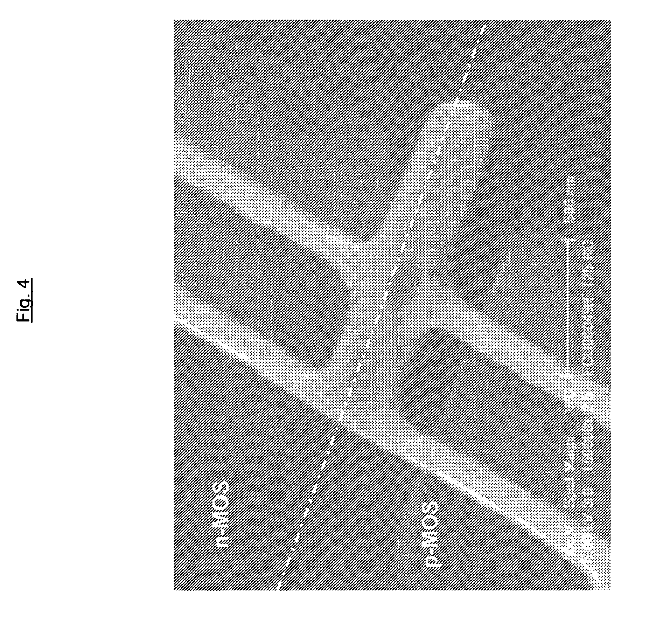

Figure 4 shows a tilted SEM of a ring oscillator structure where the poly-Si is Yb-doped for n-MOS and Aldoped for p-MOS after full dry-wet-dry etch process according to the process of the present invention.

### DESCRIPTION OF THE INVENTION

The present invention relates to a method for the patterning of a stack comprising elements that do not form volatile compounds during conventional reactive ion etching.

More specifically said element(s) are Lanthanide elements such as Ytterbium (Yb) and the patterning preferably relates to the dry etching of silicon and/or germanium comprising structures (e.g. gates) doped with a Lanthanide e.g. Ytterbium (Yb doped gates).

In case said silicon and/or germanium comprising structure is a gate electrode the silicon and/or germanium is doped with a Lanthanide (e.g. Yb) for tuning the work function of a gate electrode.

More specifically a method is disclosed for the patterning of a Si, Ge or SiGe comprising gate electrode layer further comprising one or more lanthanide dopants in a semiconductor device.

Said method comprises the steps of first providing a substrate comprising a gate dielectric layer and depositing a gate electrode layer onto said gate dielectric layer.

In a next step the gate electrode layer is doped with a suitable doping element (dopant).

Said dopant is characterized as a Lanthanide element which does not form volatile compounds during conventional reactive ion etching such as Ytterbium (Yb).

In a next step a mask structure is developed onto said gate electrode layer to define a gate structure and to expose part(s) of the gate electrode layer.

Subsequently the exposed parts of the gate electrode layer are chlorinated (and/or brominated) using an halogen comprising plasma such that the dopant is chlorinated (and/or brominated).

Said halogen comprising plasma is a Cl comprising plasma (and/or Br comprising plasma) that does not contain F.

In a next step the chlorinated (and/or brominated) doping elements (also referred to as dopants) are removed using a wet etch step.

Since Lanthanide chlorides and Lanthanide bromides are water soluble, said wet etch step is a water rinse or alternatively a rinse using an acidified water based solution.

An example of said acidified solution can be HCl in water wherein the HCl concentration can range from 1-2% till 10-20%.

To complete the gate patterning, the substrate is then transferred to the dry etch chamber to perform a dry etch step to etch the remaining part of the gate electrode layer and optionally gate dielectric layer.

To distribute the dopant, an anneal step is performed, said anneal step is preferably a thermal anneal. The anneal step is performed after the step of (selectively) removing the halogenated dopants after the step of patterning the complete gate electrode.

Preferably the step of subjecting the exposed parts of the gate electrode layer to an halogen comprising plasma is performed in a dry etch chamber using an anisotropic dry-etch plasma. Said dry etch chamber can be the same etch chamber in which the patterning of the gate structure is completed.

Preferably the step of subjecting the exposed parts of the gate electrode layer is performed by an anisotropic dry-etch plasma during the step of patterning said gate electrode layer using a Cl (and/or Br) based (or comprising) plasma whereby during the etching the exposed portions of said gate dielectric layer gets chlorinated (and/or brominated).

Preferably the Cl (and/or Br) based (or comprising) plasma is a Cl₂, HBr or BCl₃ comprising plasma.

In particular said Cl comprising plasma and/or Br comprising plasma can comprise a combination of two or three of Cl₂, HBr and BCl₃.

Preferably, the substrate is a silicon wafer.

In an alternative embodiment and also preferred an interlayer is deposited onto said substrate before depositing the gate dielectric layer.

Preferably the substrate bias during the step of subjecting the exposed parts of the gate electrode layer to a Cl- (and/or Br-) based (or comprising) plasma is 75W to 300W.

Preferably the plasma power during the step of subjecting the exposed parts of the gate electrode layer to a Cl- (and/or Br-) based (or comprising) plasma is in the range of 100W up to 1200W.

More preferred the plasma power during the step of subjecting the exposed parts of the gate electrode layer to a Cl- (and/or Br-) based (or comprising) plasma is around 250W.

Preferably the pressure in the plasma during the step of subjecting the exposed parts of the gate electrode layer to a Cl (and/or Br) based (or comprising) plasma is minimum 0.666Pa (5mT) and maximum 10.665Pa (80mT).

More preferred the pressure in the plasma during the step of subjecting the exposed parts of the gate electrode layer to a Cl- (and/or Br-) based (or comprising) plasma is 0.799Pa (6mT).

The method of the invention is illustrated for patterning of a gate electrode structure but is applicable to pattern any silicon and/or germanium comprising layer having a doping element as long as said doping element forms soluble halides.

The method of the invention for patterning of a stack of layers using a combination (or sequence) of wet etch and dry etch techniques is also referred to as dry-wet-dry etch approach.

The present invention provides a method for patterning at least one layer of a stack of layers to define a structure, said at least one layer comprising one or more Lanthanide elements and said method at least comprising the steps of:
- Providing a substrate,
- Depositing a layer onto said substrate,
- Performing a doping step to incorporate one or more Lanthanide elements in the deposited layer,
- Developing a mask structure to define a structure on said deposited layer and to expose part of the deposited layer,
- Chlorinate (and/or brominate) the Lanthanide element(s) in the exposed parts of the deposited layer using a Cl and/or Br comprising anisotropical dry etch plasma,
- Removing said chlorinated (and/or brominated) lanthanide elements using a wet etch step,
- Performing a dry etch step to etch the remaining part of the deposited layer to define a final structure.
- Annealing the substrate such that the Lanthanide (dopant) is equally distributed into the patterned structure.

Preferably, the Lanthanide element(s) are present in the stack of layers to be patterned in a concentration < 1%.

Preferably, said Cl-based (or Cl-comprising) (and/or Br-based or Br-comprising) plasma is a Cl₂ and/or BCl₃ and/or HBr/Br₂ comprising plasma.

The method can further comprise, before the step of developing a mask structure, the step of:
- Depositing photosensitive imaging layers and transferring a photolithographic pattern in said imaging layers to define the gate structure.

Preferably, the step of annealing is performed using a thermal anneal at 950°C.

Preferably, said structure is a gate structure in a semiconductor device, said deposited layer is a gate electrode layer and the method further comprises, before the step of depositing the gate electrode layer, the step of depositing a gate dielectric layer.

Preferably, said deposited layer is a polycrystalline silicon layer to be used as a gate electrode layer and said gate dielectric layer is a high-k layer, SiO₂ layer or SiON layer.

Preferably, the method further comprises, after the step of performing a dry etch step to etch the remaining part of the gate electrode layer to define a gate electrode, the step of:
- Performing a dry etch step to etch the gate dielectric layer to complete a gate structure.

Said doping element is a Lanthanide selected from at least one of La, Ce, Pr, Nd, Pm, Sm, Eu, Gd, Tb, Dy, Ho, Er, Tm, Yb and Lu.

Preferably, said doping element is Yb.

Preferably, said substrate is a silicon wafer.

Preferably, said wet etch is a water rinse.

The method for patterning can be used to fabricate a semiconductor device comprising a gate structure.

In relation to the drawings the present invention is described very briefly and general in the sequel. It is apparent, however, that a person skilled in the art knows how to perform the etch process in detail and compose an etch recipe.

In the context of the present invention, the term substrate bias refers to the voltage applied to the substrate in a Reactive Ion Etching (RIE) chamber. This value is expressed in Watts. The absence of substrate bias (Bias = 0) gives substantially no ion bombardment meaning almost no etching behavior. To achieve a vertical treatment (or exposure) of the substrate by the plasma, a substrate bias is preferred to avoid lateral etch of the structures due to exposure to plasma components.

In the context of the present invention, the term "anisotropic etch" refers to the etching process in which etch rate in the direction perpendicular to the surface (or substrate) is much higher than in direction parallel to the surface (or substrate). This in contrast to "isotropic etch" in which the etching occurs the same in any direction or being non-directional.

In the context of the present invention, the term "micromasking" refers to and is observed when a number of the residuals behave as if they were tiny islands of etchresisting material which prevent the underlying layer from being etched and hence act as a mask. Additionally, if a continuous string of such micromasking nodules occurs undesired electrical shorts may occur. Even if complete shorts are not formed, critical electrical attributes such as current leakage may be adversely affected by micromasking.

In the context of the present invention, the term Lanthanides refers to the 15 elements with atomic numbers 57 through 71, from lanthanum to lutetium. More specifically and as an example it refers in this application to Lanthanides used for doping to achieve a n-type (p-type) doping of e.g. poly-silicon.

In the context of the present invention "integrated circuit" includes devices formed on semiconducting substrates, such as group IV materials like silicon or germanium, or group III-V compounds like gallium arsenide, or structured substrate such as silicon-on-insulator, strained silicon and silicon-germanium, or mixtures of such materials. The term includes all types of devices formed, such as memory and logic, and all designs of such devices, such as MOS and bipolar. The term also comprehends applications such as flat panel displays, solar cells, and charge coupled devices.

The invention solves the problem of micromasking occurring during the patterning of poly-silicon gates doped with Lanthanides such as Ytterbium (Yb) using reactive ion dry-etching techniques. More specifically the problem is the removal of said dopant residues during the patterning thereby avoiding micromasking. The dry-etching of said Lanthanides is hardly possible at close to room temperatures due to very low volatility of Lanthanides. For example the melting point of Yb is around 824°C which is far too high to perform reactive ion etching.

It is therefore an object of the present invention to provide a method for patterning of a stack of layers (e.g. a gate stack layer) comprising elements (e.g. dopants) which are hardly possible to remove by dry etching. More specifically a method is disclosed to allow selective removal of Lanthanide dopants using semiconductor compatible process technology steps.

The invention provides a method for forming (or patterning) a structure in at least one layer (or a stack of layers) on a semiconductor substrate. More specifically said structure can be a gate structure. A layer is first deposited onto a substrate and doped with a suitable dopant. Said dopant is preferably a Lanthanide such as Yb. Subsequently the deposited layer is then patterned with a suitable mask to define a structure in said deposited layer and to expose portions of the deposited layer. The exposed portions of the deposited layer are then subjected to a halogen comprising plasma that causes chlorination (and/or bromination) of the dopant in the exposed portions of the deposited layer. Said halogen comprising plasma is preferably an in-situ plasma comprising Cl and/or Br species (and does not comprise F species). The chlorinated (and/or brominated) portions of the dopants can be selectively wet etched. Said wet etch is preferably a water based rinse (or optionally acidified water can be used). After removal of the halogenated dopants, the patterning of the structure is completed using dry etching techniques. Finally the dopants in the patterned structure need to be distributed using an anneal. Most preferred said anneal step is a thermal anneal.

The method of the invention is preferably used to pattern a stack of layers whereby at least one of the layers comprises a Lanthanide, preferably said stack of layers are gate stack layers. Said stack of layers is situated or deposited onto a substrate, most preferred said substrate is a semiconductor substrate e.g. silicon wafer. The aim of the patterning is to pattern or to form a gate structure in said gate stack layers. Said gate structure comprises at least one gate electrode (layer) and at least one gate oxide (layer) situated below said gate electrode layer.

Optionally an interlayer can be deposited onto the substrate before depositing said gate stack layers, said interlayer can be a thermally grown SiO₂ layer. Said thermally grown SiO₂ can be formed by subjecting the (silicon) substrate to a HF dip (2%HF for a few minutes).

Most preferred the gate stack layer used to form the gate electrode is a silicon and/or germanium comprising layer such as a polycrystalline-silicon (poly-Si) layer.

Most preferred the gate stack layer used to form the gate oxide (also referred to as gate insulator or gate dielectric) is a high-k layer but other suitable gate oxide layers are also possible (e.g. SiO₂, SiON).

The present invention solves the problem of patterning of gate electrode layers doped with one or more Lanthanide elements to tune the workfunction of a gate electrode, more specifically the selective removal of Lanthanides in a gate electrode layer during patterning of a gate structure is disclosed. Dry removal is impossible since Lanthanides do not form volatile compounds within the temperature ranges used during reactive ion etching (plasma etching).

The present invention solves the problem of micromasking originating from Lanthanide residues during the patterning by first performing a chlorination (and/or bromination) step using a dry-etch plasma such that Lanthanide halides are formed (e.g. YbCl₃) which are water soluble. Said chlorination (and/or bromination) step is performed after the creation of a mask structure such that only the exposed areas are chlorinated (and/or brominated). In a second step said Lanthanide halides are selectively removed from the substrate using a wet removal step. Said wet removal step is preferably performed using a deionized water rinse or alternatively a rinse with acidified water.

The method of the invention solves the problem by chlorinating (and/or brominating) the Lanthanides by means of a Cl and/or Br containing plasma (e.g. Cl₂, HBr, Br₂ and/or BCl₃).

The method of the invention further provides the advantage of selective removal of Lanthanide halides (i.e. chlorinated and/or brominated Lanthanides) only in the exposed areas and hence not under the areas protected by a (hard) mask used for patterning the gate structure.

The method of the invention furthermore provides the advantage of avoiding or eliminating the removal of non-chlorinated (and/or non-brominated) Lanthanides because these are not water soluble and hence only the chlorinated (and/or brominated) Lanthanides are removed by means of a wet rinse (preferably water).

Preferably, the plasma chlorination (and/or bromination) of the invention is anisotropic, whereby the areas of the gate electrode layer which are situated under the mask structure are not exposed and hence not chlorinated (and/or brominated) and, therefore, not removed by water.

In a preferred embodiment said chlorination or alternatively bromination step is performed after the step of doping the gate electrode layer and before the step of annealing the gate electrode layer such that the dopant elements are located in the upper (or top) region of the gate electrode layer.

Said chlorinated (and/or brominated) dopant elements can be removed by performing a wet removal step. In case the dopant element is a Lanthanide such as Yb, said wet removal of Yb-chlorides (and/or Yb-bromides) is preferably a water based removal, most preferred said removal is a water rinse.

It has been found through experimentation that the wet residue removing step removed essentially all of the exposed micromasking nodules. As a result, micromasking-created nodules are avoided.

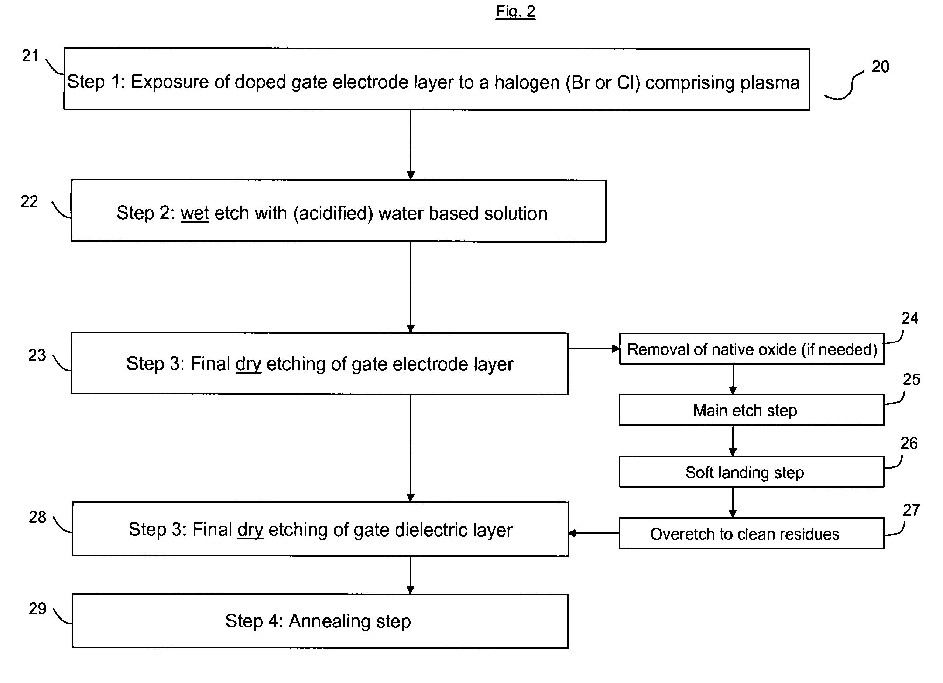

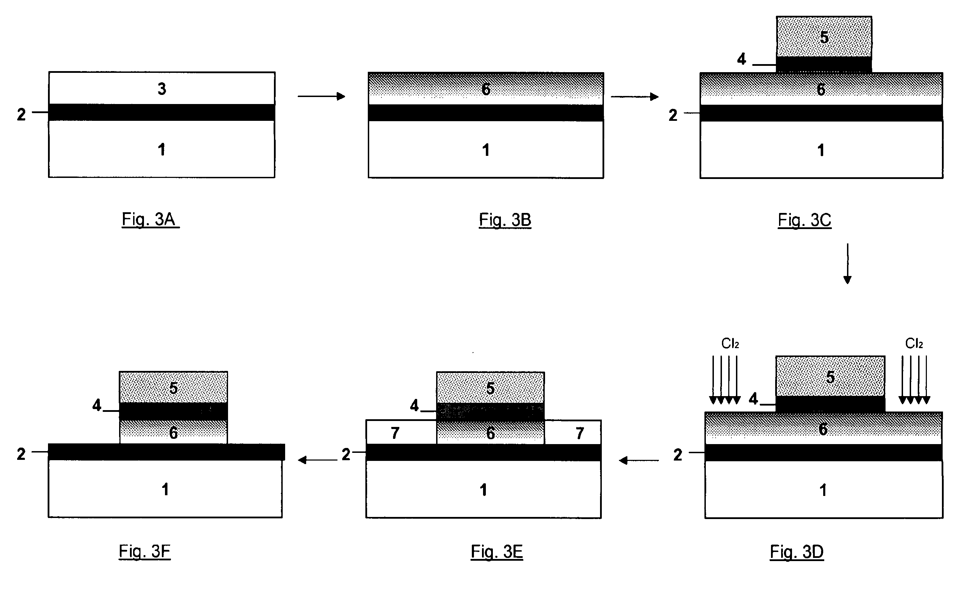

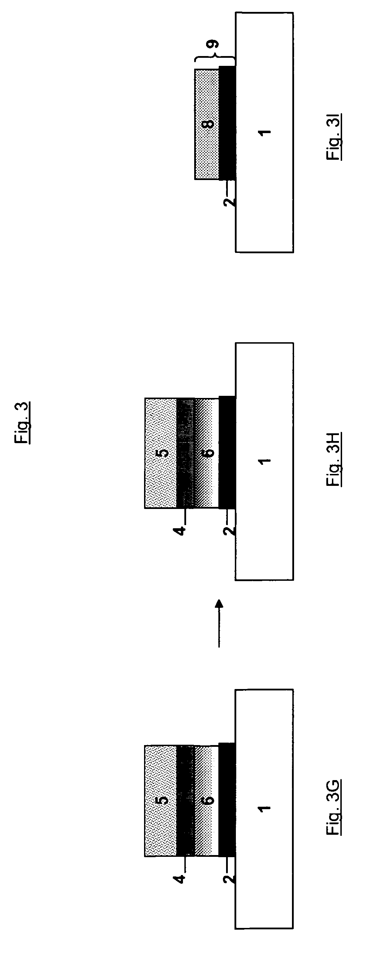

Figure 2 shows a flowchart illustrating the process flow according to a preferred embodiment of the invention wherein the dopant material is chlorinated (and/or brominated) during the patterning of the gate electrode. The description below is illustrated for patterning of a gate electrode structure but it must be clear that the method of the invention is applicable to pattern any silicon and/or germanium comprising layer comprising a minor concentration of one or more Lanthanide elements (e.g. <1%) as long as said lanthanide element forms (water) soluble halides. Figure 3 illustrates schematically the individual steps after providing a substrate with gate dielectric layer and doped gate electrode layer and having a mask on top of the gate electrode layer to pattern the gate structure (according to the dry/wet/dry approach of the present invention).

The method starts with providing a substrate **1,** most preferred said substrate **1** is a semiconductor substrate such as a Si wafer comprising active areas (e.g. source and drain). Onto said substrate **1** a gate dielectric layer **2** is deposited e.g. a silicon dioxide layer, and/or a silicon oxynitride layer (with a thickness of e.g. 2nm) and/or a high-k layer. Optionally an interlayer can be deposited onto said substrate prior to the deposition of a gate dielectric layer **2,** said interlayer can be e.g. a thermally grown SiO₂ layer obtained after a thermal anneal or an HF dip (e.g. a dip in a 2% HF solution). Onto said gate dielectric layer **2** a gate electrode layer **3** is deposited, said gate electrode layer **3** is preferably formed with a thickness of about 100nm (range 50 nm up to maximum 200 nm), and is preferably formed of poly-crystalline silicon.

In a next step the gate electrode layer **3** is doped with a suitable dopant element. Preferably said dopant element is a Lanthanide and more preferred said dopant element is Ytterbium (Yb). For example a poly-silicon gate layer is doped with Yb using 40keV at 4E¹⁵ cm⁻² or 8E¹⁵ cm⁻². After doping said gate electrode layer 6 the dopant element is situated in the upper part of the gate electrode layer (or in other words near the top surface).

In a next step, a mask layer is deposited onto said gate electrode layer **5,** most preferred said mask layer is a photosensitive imaging layer(s) **5,** and optionally there can be a hardmask layer **4** such as silicon nitride deposited before the deposition of said photosensitive imaging layer(s) **5.** A gate pattern is then transferred into said photosensitive imaging layer(s) **5** and hardmask layer **4** by means of photolithographic patterning.

In a next step the (doped) gate electrode layer **6** is subjected to an halogen plasma **21,** preferably said a halogen comprising plasma such that the dopant element is halogenated. However, the overlying mask structure prohibits the in-situ plasma from chlorination (and/or bromination) of the dopants in that region. Most preferred chlorinated and/or brominated dopants are formed in the gate electrode layer **6** which are water soluble. As illustrated in Figure 3, the exposed portions of the (doped) gate electrode layer **6** are subjected to a plasma comprising Cl and/or Br species that cause chlorination/bromination of the dopant elements in the gate electrode layer. The time and exposure of said chlorination/bromination step is such that complete chlorination/bromination of the dopants of the exposed portions of the gate electrode layer is obtained. Most preferred the step of subjecting the exposed areas of the gate electrode layer is performed in a reactive ion etch chamber e.g. in a 2300 Versys etch chamber from Lam Research whereby the substrate bias during said exposure step is different from zero to avoid lateral exposure, a suitable substrate bias can be 90W.

In a next step the chlorinated and/or brominated dopants are removed from the exposed areas of the gate electrode layer **6** by means of a wet removal step 22, most preferred said wet removal step is a water rinse. Alternatively said wet removal step uses an acidified water solution. During the wet removal step, the non exposed parts of the gate electrode layer **3** (situated under the mask layer(s) **4,5** are not etched because said non-chlorinated (and/or non-brominated) dopants are not (water) soluble.

An anisotropical dry-etching process **23** is then applied to etch (complete) a gate structure **9** in said gate electrode layer **3** and gate dielectric layer **2.** The plasma used to pattern the gate electrode layer **3** or in other words to perform the main etch step **25** is a conventional plasma used to pattern e.g. poly crystalline silicon. The main etch plasma (to define 80% of the gate electrode profile) for etching of the undoped Poly-Si preferably comprises HBr, Cl₂, CF₄ and/or O₂ as etch gases. After the main gate etch step a soft landing (SL) step **26** is performed whereby the etch plasma is tuned to be selective towards the underlying dielectric. This SL plays a key role for determining the bottom profile of the gate. In case the underlying gate dielectric is SiON, the SL etch plasma preferably contains HBr and O₂. Additionally an extra overetch (OE) step **27** can be applied after the SL step to clean up (Si) etch residues. The anisotropical dry-etching process further comprises the step of etching **28** the gate dielectric layer **2** using the above mentioned mask (gate pattern) to define a complete gate structure **9.** In all the above plasma compositions, the plasma can further comprise inert compounds. Finally a resist strip or removal of the mask structure **4,5** is applied.

An anneal used to diffuse the dopants over the poly-Si layer can not be applied before the step of patterning the gate electrode layer without affecting the gate profile and needs to be applied after the step of patterning the gate electrode. Said thermal anneal step **29** must performed after the step of removing the halogenated dopants in the exposed areas. Said anneal can be performed at 950°C for 30s in N₂ ambient obtained.

Preferably, the Cl (and/or Br) comprising plasma used to perform the chlorination (and/or bromination) of the dopant element such as Yb has a plasma power in the range of 100W up to 1200W. More preferred said plasma power is around 250W.

Preferably, the pressure in the plasma chamber used to perform the chlorination (and/or bromination) of the dopant element of the present invention (during patterning or after patterning of the gate electrode) is in the range of minimum 0.666 Pa (5mT) and maximum 10.665 Pa (80mT). More preferred said pressure is 0.799 Pa (6mT).

Preferably, the chlorine (and/or bromine) comprising plasma used to perform the chlorination (and/or bromination) of the dopant element of the present invention (during patterning or after patterning of the gate electrode) has a plasma temperature below 100°C and most preferred said plasma temperature during dry-etch patterning is around 60°C.

The preferred time of exposure of the gate electrode layer to the Cl (and/or Br) comprising plasma is dependent on the dopant concentration and the plasma settings such as substrate bias, etc. A higher substrate bias will give more ion bombardment and can therefore reduce thickness of the gate electrode layer during exposure to the Cl (and/or Br comprising) plasma.

If needed the sequence of first a step of chlorination (and/or bromination) in a Cl and/or Br comprising plasma followed by the step of removing the chlorinated (and/or brominated) dopants in the exposed areas of the gate electrode layer can be repeated until complete removal (selective) of the dopants in the exposed areas of the gate electrode layer is obtained.

It is further an aim of the invention to disclose the use of a Cl and/or Br based (or comprising) plasma for the chlorination (and/or bromination) of the dopants in the exposed areas of e.g. a gate electrode layer such that a selective removal of dopants in the exposed areas of the gate electrode layer towards silicon based material (e.g. poly-silicon) is possible. Said removal can be performed using a wet removal step, most preferred said wet removal step is a water rinse.

### EXAMPLES

### Example 1: Conventional patterning scheme (prior art) for patterning of poly-Si doped gates with Ytterbium

The Poly-Si gates are 100nm thick and are patterned using a 80nm PECVD oxide hard mask. Deep UV resist (193nm wavelength) is used in combination with an organic bottom anti-reflective coating (BARC) with thickness of 230nm and 77nm, respectively. 2nm SiON is used as gate dielectric. Poly-Si was implanted either with Al (8keV or 10keV at 4E¹⁵ cm⁻²) or Yb (40keV at 4E¹⁵ cm⁻² or 8E¹⁵ cm⁻²) . The dry etch experiments were performed in a 2300 Versys etch chamber from Lam Research on 200mm wafers.

The poly-Si gate etch recipe contains three basic steps: a Main Etch (ME), a Soft Landing (SL) and an OverEtch (OE) step. The ME defines 80% of the gate. For etching of the undoped Poly-Si it contains HBr, Cl₂, CF₄ and O₂ as etch gases. The gate etch is finished by the SL step containing HBr and O₂. The SL step is tuned to be selective towards the underlying dielectric. This SL plays a key role for determining the bottom profile of the gate. OE is used to clean up Si residues and does not affect the poly-Si gate profile formed during the two previous steps.

Poly-Si gates doped with Al can be etched using the conventional recipe developed for undoped poly-Si gates. Gates with straight profile are obtained. An anneal at 950°C for 30s in N₂ ambient to diffuse the dopants over the poly-Si layer can be applied before the gate etch without affecting the gate profile obtained.

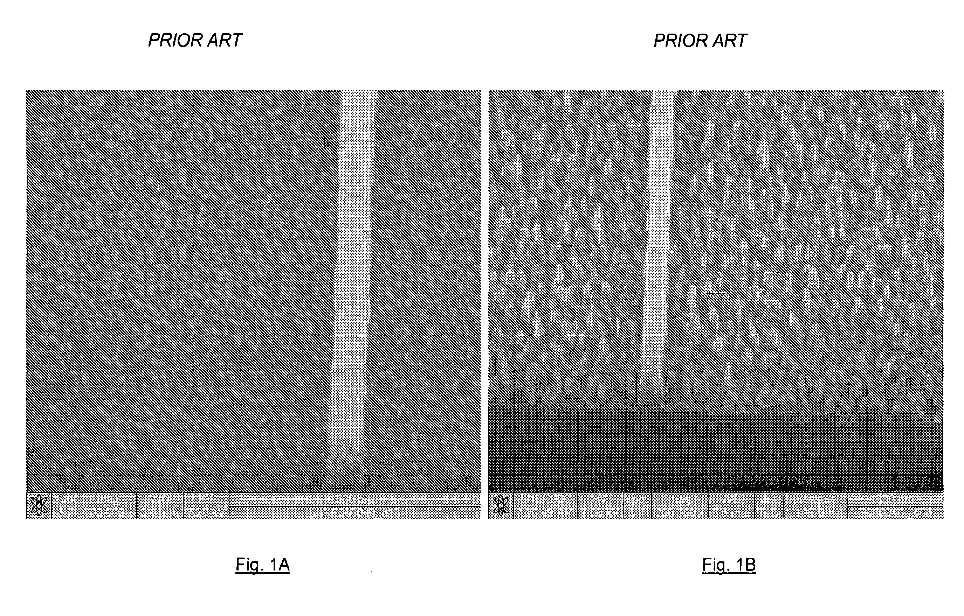

When the Yb-doped poly-Si gates are etched using conventional poly-Si gate etch recipe, Si residues as well as pitting through the gate dielectric are observed as illustrated by figure 1A. These Si residues are likely due to micro masking caused by the Yb atoms located shallow under the oxide hard mask. If an anneal at 950°C for 30s is applied to distribute the Yb atoms in the full poly-Si layer, the micro masking becomes worse (figure 1B). Si pillars as high as the gate height are seen after the gate etch.

### Example 2: Role of wet etching step in the patterning scheme for patterning poly-Si doped with Ytterbium

To verify the role of the wet etch in the patterning of Yb doped poly-Si, two wafers with the same implant energy of 4keV but double dose of Yb (8E¹⁵ cm⁻²) were etched. The first wafer is etched using the fully dry approach with the Main Etch containing only HBr and Cl₂. The second wafer is patterned using the dry-wet-dry etch approach. The dry etch times are kept the same for both wafers. Specifically, the total ME time (time before wet etch plus time after wet etch) is kept equal to the ME time applied for the dry-only approach. Severe micro masking is present when the dry-only approach is used while limited residues are observed when the intermediate wet etch is employed (figure 3). This confirms that the acidified water solution plays a crucial role in removing of the Yb bromides and/or Yb chlorides formed during the ME step.

## Claims

1. A method for patterning a layer doped with lanthanides for the manufacture of a semiconductor device comprising selectively removing a layer doped with lanthanides (6) over a layer underneath, said selective removal comprising the steps of:
- providing a substrate,
- depositing the layer over the layer underneath and doping the layer with lanthanide(s),
- forming a mask structure (4,5) to expose a part of said layer (6),
- subjecting the exposed part of said doped layer, to a Cl-comprising plasma and/or a Br-comprising plasma (21) for chlorinating and/or for brominating said lanthanide(s),
- contacting or rinsing (22) the resulting chlorinated and/or brominated doped layer with an aqueous solution, preferably with water, thereby
removing the chlorinated and/or brominated lanthanide(s),
- performing a dry etch step (23) to etch the remaining part of the exposed part of said doped layer,
- annealing (29) the substrate such that the lanthanide(s) is/are equally distributed into the patterned structure.

2. A method according to claim 1, wherein said subjecting step and said contacting step are repeated at least once.

3. A method according to any of claims 1 to 2, wherein said lanthanide(s) is/are selected from the group consisting of La, Dy, Pr, Nd, Gd, Tb, Ho, Er, Tm, Yb, and Lu.

4. A method according to any of claims 1 to 3, wherein said lanthanide is ytterbium, Yb.

5. A method according to any of claims 1 to 4, wherein said lanthanide(s) in said doped layer (6) is/are in a concentration smaller than 1%.

6. A method according to any of claims 1 to 5, wherein said Cl-comprising plasma (21) is a Cl₂ and/or BCl₃ comprising plasma.

7. A method according to any of claims 1 to 6, wherein said Br-comprising plasma (21) is a HBr and/or Br₂ comprising plasma.

8. A method according to any of claims 1 to 7, wherein said doped layer (6) consists of a silicon and/or germanium comprising layer suitable for dry-etching (23).

9. A method according to any of claims 1 to 7, wherein said doped layer (6) consists of a polycrystalline silicon layer.

10. A method according to any of claims 1 to 9, wherein said substrate (1) comprises silicon

11. A method according to any of claims 1 to 10, wherein said plasma is anisotropically applied.

12. A method for patterning a stack of layers comprising at least said layer doped with lanthanides (6), said method comprising the steps of:
- developing a mask structure (4,5) for defining a structure on said layer doped with lanthanides (6),
- exposing part of said doped layer,
- selectively removing said exposed part of said doped layer according to a method of any of claims 1 to 11.

13. A method according to claim 12, further comprising, before the step of developing a mask structure, the steps of:
- depositing photosensitive imaging layers (5), and
- transferring a photolithographic pattern in said imaging layers to define a gate structure.

14. A method according to claim 1 to 13, wherein the step of annealing is performed using a thermal anneal at 950°C.

15. A method according to any of claims 12 to 14, wherein said structure is a gate structure (9) in a semiconductor device, wherein said doped layer (6) is a gate electrode layer (3), and wherein the method further comprises before the step of depositing the gate electrode layer (3) the step of depositing a gate dielectric layer (2).

16. A method according to any of claims 12 to 15, wherein said doped layer (6), used as a gate electrode layer (3), is a poly-crystalline silicon layer and wherein said underneath layer, used as a gate dielectric, is a layer of a material having a dielectric constant higher than that of SiO₂, a SiO₂ layer, or a SiON layer.

17. A method according to any of claims 12 to 16, further comprising the step of dry etching (28) the gate dielectric layer (2) to complete the gate structure (9).

## Patentansprüche

1. Verfahren zum Mustern einer mit Lanthanoiden dotierten Schicht zur Herstellung eines Halbleiterbauelements, selektives Entfernen einer mit Lanthanoiden dotierten Schicht (6) über einer darunter liegenden Schicht umfassend, wobei das selektive Entfernen die folgenden Schritte umfasst:
- Bereitstellen eines Substrats,
- Aufbringen der Schicht über der darunter liegenden Schicht und Dotieren der Schicht mit Lanthanoid(en),
- Bilden einer Maskenstruktur (4, 5), um einen Teil der Schicht (6) freizulegen,
- Aussetzen des freigelegten Teils der dotierten Schicht, zum einem Cl umfassenden Plasma und/oder einem Br umfassenden Plasma (21) zum Chlorieren und/oder Bromieren des Lanthanoids oder der Lanthanoiden,
- In-Kontakt-bringen oder Spülen (22) der entstandenen chlorierten und/oder bromierten dotierten Schicht mit einer wässrigen Lösung, vorzugsweise mit Wasser, dadurch entfernen des chlorierten und/oder bromierten Lanthanoids oder der chlorierten und/oder bromierten Lanthanoiden,
- Ausführen eines Trockenätzschritts (23) um den restlichen Teil des freigelegten Teils der dotierten Schicht zu ätzen,
- derartiges Ausheilen (29) des Substrats dass das/die Lanthanoid(e) gleichmäßig in die gemusterte Struktur verteilt wird bzw. werden.

2. Verfahren nach Anspruch 1, wobei der Schritt des Aussetzens und der Schritt des In-Kontakt-bringens mindestens einmal wiederholt werden.

3. Verfahren nach einem der Ansprüche 1 bis 2, wobei das/die Lanthanoid(e) aus der Gruppe bestehend aus La, Dy, Pr, Nd, Gd, Tb, Ho, Er, Tm, Yb, und Lu ausgewählt ist bzw. sind.

4. Verfahren nach einem der Ansprüche 1 bis 3, wobei das Lanthanoid Ytterbium, Yb, ist.

5. Verfahren nach einem der Ansprüche 1 bis 4, wobei das/die Lanthanoid(e) in der dotierten Schicht (6) in einer Konzentration von weniger als 1 % vorliegt bzw. vorliegen.

6. Verfahren nach einem der Ansprüche 1 bis 5, wobei das Cl umfassende Plasma (21) ein Cl₂ und/oder BCl₃ umfassendes Plasma ist.

7. Verfahren nach einem der Ansprüche 1 bis 6, wobei das Br umfassende Plasma (21) ein HBr und/oder Br₂ umfassendes Plasma ist.

8. Verfahren nach einem der Ansprüche 1 bis 7, wobei die dotierte Schicht (6) aus einer Silicium und/oder Germanium umfassenden Schicht besteht, die für Trockenätzen (23) geeignet ist.

9. Verfahren nach einem der Ansprüche 1 bis 7, wobei die dotierte Schicht (6) aus einer polykristallinen Siliciumschicht besteht.

10. Verfahren nach einem der Ansprüche 1 bis 9, wobei das Substrat (1) Silicium oder Germanium umfasst.

11. Verfahren nach einem der Ansprüche 1 bis 10, wobei das Plasma anisotrop aufgebracht wird.

12. Verfahren zum Mustern eines Stapels von Schichten, der mindestens die mit Lanthanoid(en) dotierte Schicht (6) umfasst, wobei das Verfahren die folgenden Schritte umfasst:
- Entwickeln einer Maskenstruktur (4, 5) zum Definieren einer Struktur auf der mit Lanthanoid(en) dotierten Schicht (6),
- Freilegen eines Teils der Schicht,
- selektives Entfernen des freigelegten Teils der dotierten Schicht gemäß einem Verfahren nach einem der Ansprüche 1 bis 11.

13. Verfahren nach Anspruch 12, ferner umfassend, vor dem Schritt des Entwickelns einer Maskenstruktur, die folgenden Schritte:
- Aufbringen von fotosensitiven Abbildungsschichten (5), und
- Übertragen eines fotolithografischen Musters in den Abbildungsschichten um eine Gatestruktur zu definieren.

14. Verfahren nach Anspruch 1 bis 13, wobei der Schritt des Ausheilens unter Verwendung eines thermischen Ausheilens bei 950 °C ausgeführt wird.

15. Verfahren nach einem der Ansprüche 12 bis 14, wobei die Struktur eine Gatestruktur (9) in einem Halbleiterbauelement ist, wobei die dotierte Schicht (6) eine Gateelektrodenschicht (3) ist, und wobei das Verfahren ferner den Schritt des Aufbringens einer Gatedielektrikumschicht (2) vor dem Schritt des Aufbringens der Gateelektrodenschicht (3) umfasst.

16. Verfahren nach einem der Ansprüche 12 bis 15, wobei die dotierte Schicht (6), die als eine Gateelektrodenschicht (3) verwendet wird, eine polykristalline Siliciumschicht ist und wobei die darunter liegende Schicht, die als ein Gatedielektrikum verwendet wird, eine Schicht aus einem Material ist das eine dielektrische Konstante aufweist die höher als die von SiO₂, einer SiO₂-Schicht, oder einer SiON-Schicht ist.

17. Verfahren nach einem der Ansprüche 12 bis 16, ferner den Schritt des Trockenätzens (28) der Gatedielektrikumschicht (2)umfassend um die Gatestruktur (9) zu vollenden.

## Revendications

1. Procédé de formation de motif d'une couche dopée avec des lanthanides pour la fabrication d'un dispositif semi-conducteur comprenant l'élimination sélective d'une couche dopée avec des lanthanides (6) sur une couche sous-jacente, ladite élimination sélective comprenant les étapes de :
- fourniture d'un substrat,
- dépôt de la couche sur la couche sous-jacente et dopage de la couche avec un (des) lanthanide(s),
- formation d'une structure de masque (4, 5) pour exposer une partie de ladite couche (6),
- soumission de la partie exposée de ladite couche dopée à un plasma comprenant du CI et/ou à un plasma comprenant du Br (21) pour chlorer et/ou pour bromer le(s)dit(s) lanthanide(s),
- mise en contact ou rinçage (22) de la couche dopée chlorée et/ou bromée résultante avec une solution aqueuse, de préférence avec de l'eau, pour ainsi éliminer le(s) lanthanide(s) chloré(s) et/ou bromé(s),
- réalisation d'une étape de gravure sèche (23) pour graver la partie restante de la partie exposée de ladite couche dopée,
- recuit (29) du substrat de manière à ce que le(s) lanthanide(s) est/soit distribué(s) de manière homogène dans la structure à motif.

2. Procédé selon la revendication 1, dans lequel ladite étape de soumission et ladite étape de mise en contact sont répétées au moins une fois.

3. Procédé selon l'une quelconque des revendications 1 à 2, dans lequel le(s)dit(s) lanthanide(s) est/sont choisi(s) dans le groupe constitué du La, du Dy, du Pr, du Nd, du Gd, du Tb, de l'Ho, de l'Er, du Tm, du Yb et du Lu.

4. Procédé selon l'une quelconque des revendications 1 à 3, dans lequel ledit lanthanide est de l'ytterbium (Yb).

5. Procédé selon l'une quelconque des revendications 1 à 4, dans lequel le(s)dit(s) lanthanide(s) de ladite couche dopée (6) est/sont en une concentration inférieure à 1 %.

6. Procédé selon l'une quelconque des revendications 1 à 5, dans lequel ledit plasma comprenant du Cl (21) est un plasma comprenant du Cl₂ et/ou du BCl₃.

7. Procédé selon l'une quelconque des revendications 1 à 6, dans lequel ledit plasma comprenant du Br (21) est un plasma comprenant de l'HBr et/ou du Br₂.

8. Procédé selon l'une quelconque des revendications 1 à 7, dans lequel ladite couche dopée (6) consiste en une couche comprenant du silicium et/ou du germanium adaptée à la gravure sèche (23).

9. Procédé selon l'une quelconque des revendications 1 à 7, dans lequel ladite couche dopée (6) est constituée d'une couche de silicium polycristallin.

10. Procédé selon l'une quelconque des revendications 1 à 9, dans lequel ledit substrat (1) comprend du silicium ou du germanium.

11. Procédé selon l'une quelconque des revendications 1 à 10, dans lequel ledit plasma est appliqué anisotropiquement.

12. Procédé de formation de motif d'un empilement de couches comprenant au moins ladite couche dopée avec des lanthanides (6), ledit procédé comprenant les étapes de :
- développement d'une structure de masque (4, 5) pour définir une structure sur ladite couche dopée avec des lanthanides (6),
- exposition d'une partie de ladite couche dopée,
- élimination sélective de ladite partie exposée de ladite couche dopée par un procédé selon l'une quelconque des revendications 1 à 11.

13. Procédé selon la revendication 12, comprenant en outre, avant l'étape de développement d'une structure de masque, les étapes de :
- dépôt de couches d'imagerie photosensibles (5), et
- transfert d'un motif photolithographique dans lesdites couches d'imagerie pour définir une structure de type grille.

14. Procédé selon la revendication 1 à 13, dans lequel l'étape de recuit est réalisée en utilisant un recuit thermique à 950 °C.

15. Procédé selon l'une quelconque des revendications 12 à 14, dans lequel ladite structure est une structure de type grille (9) dans un dispositif semi-conducteur, dans lequel ladite couche dopée (6) est une couche d'électrode de grille (3), et dans lequel le procédé comprend en outre avant l'étape de dépôt de la couche d'électrode de grille (3) l'étape de dépôt d'une couche de diélectrique de grille (2).

16. Procédé selon l'une quelconque des revendications 12 à 15, dans lequel ladite couche dopée (6), utilisée en tant que couche d'électrode grille (3), est une couche de silicium polycristallin et dans lequel ladite couche sous-jacente, utilisée en tant que diélectrique de grille, est une couche constituée d'un matériau ayant une constante diélectrique supérieure à celle du SiO₂, d'une couche de SiO₂, ou d'une couche de SiON.

17. Procédé selon l'une quelconque des revendications 12 à 16, comprenant en outre l'étape de gravure sèche (28) de la couche de diélectrique de grille (2) pour achever la structure de type grille (9).
